# EUROPEAN PATENT APPLICATION

(11) **EP 3 205 792 A1**
(43) Date of publication of application: **16.08.2017**
(21) Application number: 17155829.9
(22) Date of filing: 13.02.2017
(51) Int. Cl.: E04H 1/12, E04H 5/02, H05K 5/06, H05K 7/20, E04H 5/04, F24F 12/00

(54) **CONTAINMENT STRUCTURE FOR ELECTRIC OR ELECTRONIC APPARATUSES, AND RELATED COMPOSITE WALL**

(30) Priority: 15.02.2016 IT UB20160739
(71) Applicant: Mazzilli, Mauro, 00046 Grottaferrata (RM) (IT); Cappuccio, Adriana, 00046 Grottaferrata (RM) (IT)
(72) Inventor: Mazzilli, Mauro, 00046 Grottaferrata (RM) (IT)
(74) Representative: Leone, Mario

(57) **Abstract**

A containment structure (1) for electric or electronic apparatuses (20) allows to refrigerate the internal portion thereof by acting only in the air gap inside the panels constituting the structure, wherein it is possible to create a natural or forced ventilation without inputting air inside the structure, and it has a plurality of composite walls (2) comprising: a first insulating panel (4), which has a layer (6) made of insulating material formed by an agglomeration of resin and plastic and/or vitreous particulate, faced towards outside the containment structure (1); a second panel (7) made of conductive material, formed by one or more metal plates (8) having an inner face (9), directed towards the inside of the containment structure (1), and an outer face (10) facing towards said first panel (4); an aerated air gap (15) between said first and second panel (4, 7); e a plurality of fins (12) made of conductive material, fastened on the outer face (10) of the second panel (7), with a distal end (13) spaced apart from said first panel (4), arranged in vertical position, so as to form a plurality of vertical channels (14) on the outer face (10) of the second panel (7).

## Description

The present invention relates to a containment structure for electric or electronic apparatuses, the operation thereof involves a production of heat which has to be disposed of outside the containment structure.

The invention also relates to a composite wall which can be used for constructing containment structures of the type specified above.

This type of structures can be used for example to receive electronic instruments for data transmission, to transform the voltage in medium-low voltage stations, to include servers and processors and so on. Generally, they provide to such apparatuses a closed environment, protected from humidity excesses, changes in temperature, polluting agents such as powders or toxic or corrosive substances, break-in and entrance of animals such as insects or small rodents.

In most operation cases, the structure has then to be closed, except from service openings for entering ducts, cables, pipes and the like.

Containment structures are known which allow to dispose of the heat produced inside thereof; generally they have a system for circulating cooling air which is made to circulate inside the structure, so that it behaves like a heat-carrying fluid.

However, the air circulation involves some problems. In fact, it requests the presence of valves or other ventilation systems requesting a huge energy input which, apart from affecting the apparatus management costs, involves an environmental damage and it produces a noise which could be heard even far from the apparatus and thus it could result to be irritating, in particular if the structure is near a residential area.

Furthermore, the forced ventilation systems cease to operate if they are not power-supplied and, in case of black-out, dangerous heat storages could occur with consequent risk of fire.

It is further to be meant that the disposal of the residual heat is not the only purpose of the containment structure, as it has to provide even other protection forms against outer agents already mentioned previously.

US patent N. 4,480,225 A describes a containment structure for electric apparatuses with a wall formed by a pair of panels separated by an air gap, wherein an improvement of the heat extraction can be obtained only by increasing the load related to the forced air circulation in such air gap.

German patent application N. 20 46 396 A1, instead, describes a containment structure with an air gap in its walls, provided for insulating purposes as a whole.

The technical problem underlying the present invention is to provide a containment structure allowing to obviate the drawback mentioned by referring to the known art.

Such problem is solved by a containment structure as specified above which characterizes in that it has a plurality of composite walls comprising:
- a first insulating panel, which has a layer made of insulating material formed by an agglomeration of resin and plastic and/or vitreous particulate, faced towards outside the containment structure;
- a second panel made of conductive material, formed by one or more metal plates having an inner face, directed towards the internal portion of the containment structure, and an outer face facing towards said first panel;
- an aerated air gap between said first and second panel; and
- a plurality of fins made of conductive material, fastened on the outer face of the second panel, with a distal end spaced apart from said first panel, arranged in vertical position, so as to form a plurality of vertical channels on the outer face of the second panel.

Herein and hereinafter, under vertical the orientation of the longitudinal extensions of the fins and of the respective channels formed thereby with respect to the ground are meant, that is at the base of the containment structure.

The main advantage of the containment structure according to the present invention lies in the fact of allowing a refrigeration of the internal portion thereof by acting only in the air gap inside the panels constituting the structure, wherein it is possible to create a natural or forced ventilation without inputting air inside the structure.

The present invention will be described hereinafter according to a preferred embodiment example thereof, provided by way of example and not for limitative purposes by referring to the enclosed drawings wherein:
* figure 1 shows, on a cross section of a composite wall, a scheme illustrating the operation of the wall of a containment structure according to the present invention;
* figure 2 shows a front view of a containment structure according to the invention constructed partially;

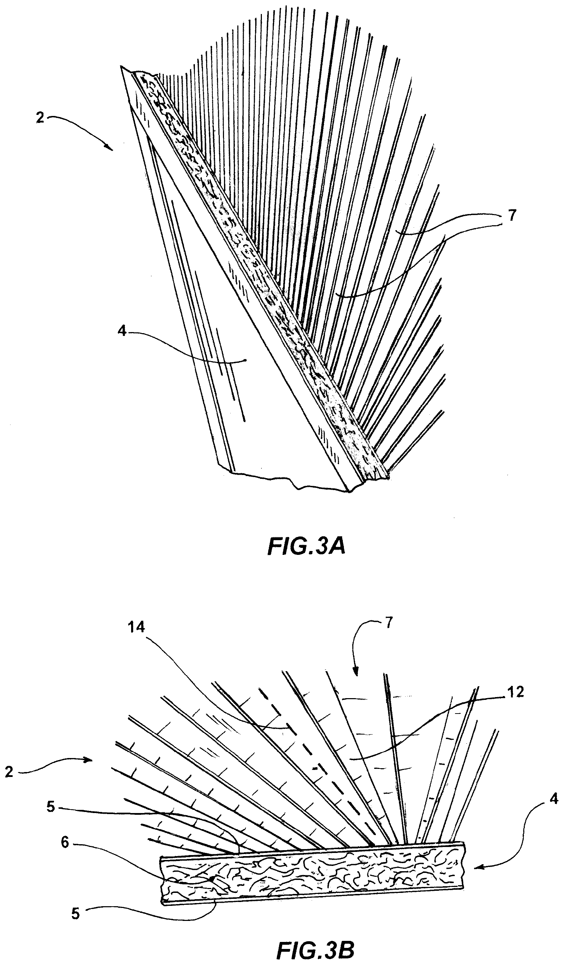

* figure 3A shows a composite wall of a containment structure according to the invention, with a partial section of a portion thereof;
* figure 3B shows the view of figure 2 from a different angulation;
* figure 4 shows an axonometric view illustrating the assembly of a composite wall of a containment structure according to the present invention;
* figure 5 shows a top plan view illustrating the assembly of a composite wall of a containment structure according to the present invention; and

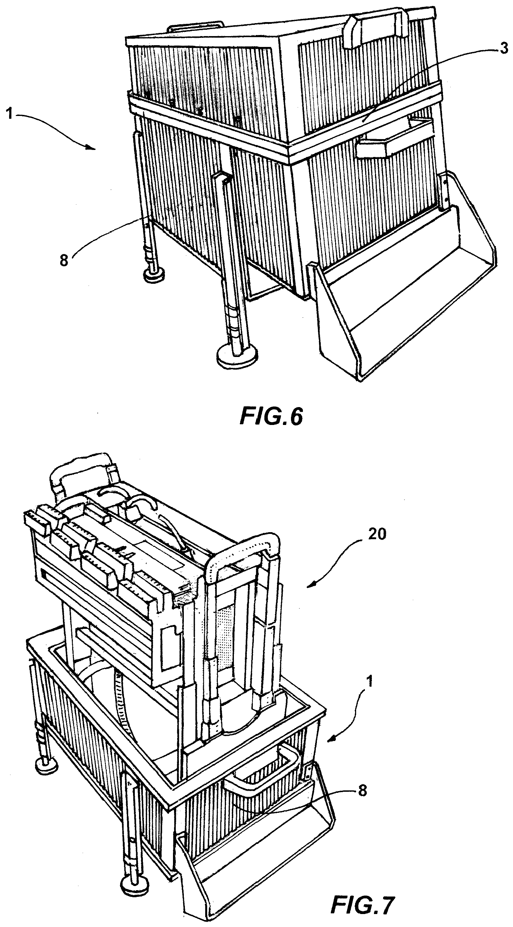

* figures 6 and 7 show a containment structure according to the invention, closed and open respectively, without the outer coverings.

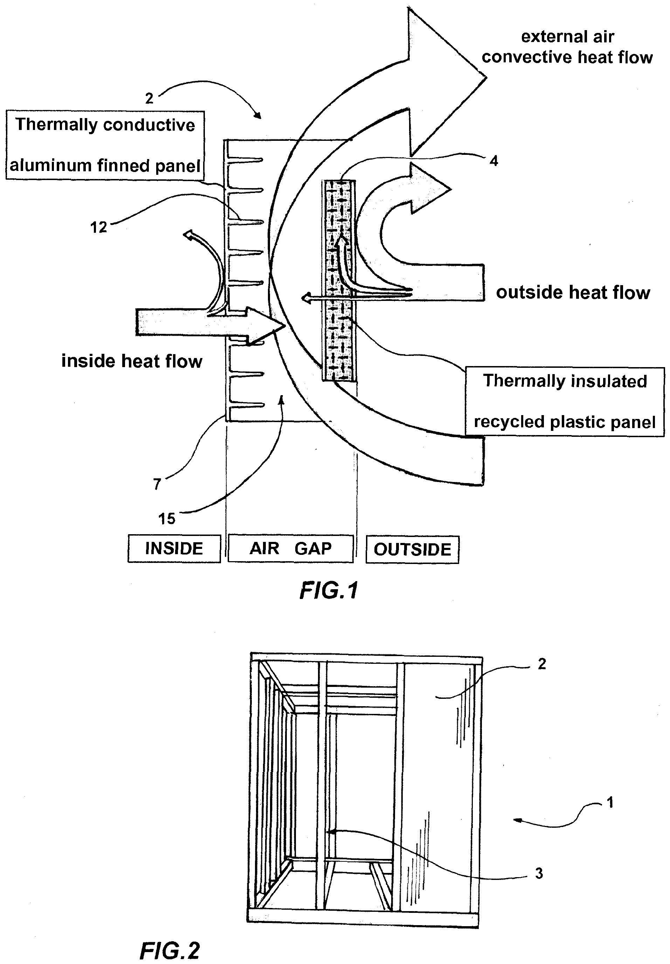

By referring to figure 1, the operation of a containment structure is illustrated in relation to a composite wall thereof constituting it. In fact, the structure, designated as whole with 1, can be implemented by means of a box-like configuration, with a plurality of composite walls 2 formed by panels assembled therebetween and a suitable frame 3 (figure 2). They form a box-like structure which can be parallelepiped shaped or can have a more complex shape.

The composite wall 2 then comprises a first insulating panel 4 which is formed by a pair of outer containment layers 5, made of cardboard, wood or plastic material, therebetween an insulating layer 6 made of synthetic insulating material is provided.

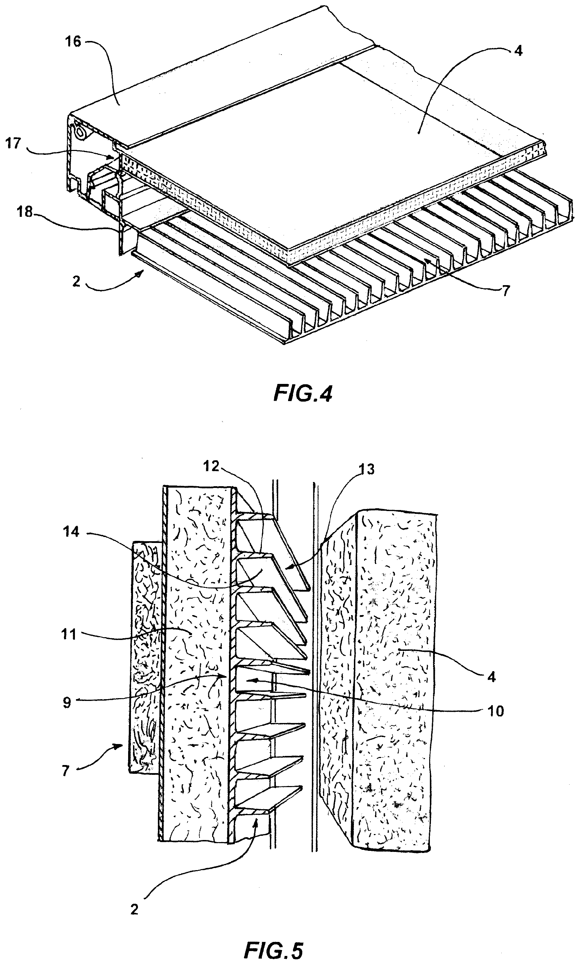

Alternatively, the insulating layer 6 can be of self-supporting type which does not require containment layers (figure 5).

The insulating layer 6 then can be formed in several ways. For example, it can be constituted by a solidified foam, comprising fibres which provide bearing capacity.

A preferred version of the insulating layer 6 provides an agglomerate of resin and plastic and/or vitreous particulate, faced towards outside the containment structure.

The resin can be a hardening resin, mixed with a grit which can constitute up to 90% of the total filling volume, with a minimum of 50%.

According to a preferred version, said grit can comprise a granulate made of polyester or other plastic material, and a vitreous particulate, possibly with cutting edges, which has the function of preventing the rodents from nibbling the filler.

A granulate made of plastic material suitable to the purpose derives from grinding waste made of plastic material, by constituting a possibility for the disposal thereof which does not require its incineration in a waste-to-energy plant.

The first panel 4 is faced towards outside the containment structure 1.

Said composite wall 2 further comprises a second panel 7 made of conductive material, formed by one or more metal plates 8 having an inner face 9, directed towards the internal portion of the containment structure 2, and an outer face 10 facing towards said first panel 4.

Preferably, said metal plates 8 are formed by an aluminium sheet, but it is meant that another metal material can be suitable to the aim.

In particular applications, the metal plates 8 can be adhered to an additional structural layer 11 connected, for example glued, to the inner face 9 of the second panel 7.

In the specific case, this additional layer 11 can be formed like the first panel 4, based upon one of the above-described variants.

On the outer face thereof 10, the second panel 7 comprises a plurality of fins 12 made of conductive material; they can be fastened with a suitable thermally conductive glue to said outer face.

Advantageously, both the second panel 7 and the fins 12 are made of aluminium; the fins 12 are constituted by simple metal bands with constant height and thickness which can be constant or it can decrease from the base to the distal end 13.

It is to be noted that the distal end thereof 13 is spaced apart from said first panel. The fins 12 are arranged in vertical position, so as to form a plurality of vertical channels 14 on the outer face 10 of the second panel 7.

Due to the effect of this distance, between the first and the second panel 4, 7 an aerated air gap 15 is formed; the aeration can be guaranteed by suitable (not shown) openings implemented in the first panel 4 at the base thereof and at the top thereof. Thanks to them, due to the effect of the heating of the second panel 7 and of the related fins 13, the air included between the panels 4, 7 is subjected to a motion of natural convection due to the so-called chimney effect.

The thermal sizing of the fins 12, of the air gap 15 and of the related load losses, and of the aeration openings could be performed based upon the expected heat produced inside the containment structure.

It is to be meant that the natural convection could be made more effective by transforming it into a mixed natural-forced convection, by applying suitable sucking or blowing valves at one or more of said openings. In each case, these valves should aerate only a space with limited sizes, constructed so as not to offer great aerodynamic resistances to the air passage.

The above-described panels could be assembled together thanks to profiles 16 which form a suitable air gap of thermal cutting type made of aluminium alloy. In such profiles a first seat 17 for the first panel 4 and a second seat 18 for the second panel 7 (figure 4) could be obtained.

According to a variant, the containment structure 1 could be constituted by plates 8 equipped with fins 12, thus by forming second panels 7 to form the box-like structure including an electric or electronic apparatus 20.

This box-like structure could be then inserted in an additional (not represented) box-like structure formed by insulating panels, thus by implementing, during these assembling steps, a containment structure according to the present invention.

The additional box-like structure could be formed by walls assembled to an air gap, or it could be a compartment implemented as construction work, with insulating walls made of concrete or other suitable material, by leaving between them and the finned panels 8 an air gap 15 as previously described.

To the above-described containment structure a person skilled in the art, with the purpose of satisfying additional and contingent needs, could introduce several additional modifications and variants, however all comprised within the protection scope of the present invention, as defined by the enclosed claims.

## Claims

1. A containment structure (1) for electric or electronic apparatuses (20) having a plurality of composite walls (2) comprising:
• a first panel (4);
• a second panel (7) made of conductive material, formed by one or more metal plates (8) having an inner face (9), directed towards the inside of the containment structure (1), and an outer face (10) facing towards said first panel (4);
• an aerated air gap (15) between said first and second panel (4, 7); and
• a plurality of fins (12) made of conductive material, fastened on the outer face (10) of the second panel (7), with a distal end (13) spaced apart from said first panel (4), arranged in vertical position, so as to form a plurality of vertical channels (14) on the outer face (10) of the second panel (7),
**characterized in that** said first panel (4) is insulating and has a layer (6) made of insulating material formed by an agglomeration of resin and plastic and/or vitreous particulate, faced towards outside the containment structure (1).

2. The containment structure (1) according to claim 1, wherein the first insulating panel 4 which is formed by a pair of outer containment layers (5), therebetween an insulating layer is provided (6).

3. The containment structure (1) according to claim 1, wherein the content of plastic and/or vitreous particulate is comprised between 50% and 90% of the total filling volume.

4. The containment structure (1) according to claim 1, wherein the plastic and/or vitreous particulate comprises vitreous particulate with cutting edges.

5. The containment structure (1) according to claim 1, wherein the plastic and/or vitreous particulate comprises grinding waste made of plastic material.

6. The containment structure (1) according to claim 1, wherein said fins (12) are fastened with a suitable thermally conductive glue to said outer face (10).

7. The containment structure (1) according to claim 1, wherein said air gap (15) is aerated by means of natural convection.

8. The containment structure (1) according to claim 1, wherein said air gap (15) is aerated by means of mixed natural-forced convection.

9. A composite wall (2) for containment structures (1) of electric or electronic apparatuses (20), comprising:
• a first panel (4);
• a second panel (7) made of conductive material, formed by one or more metal plates (8) having an inner face (9), directed towards the inside of the containment structure (1), and an outer face (10) facing towards said first panel (4);
• an aerated air gap (15) between said first and second panel (4, 7); e
• a plurality of fins (12) made of conductive material, fastened on the outer face (10) of the second panel (7), with a distal end (13) spaced apart from said first panel (4), arranged in vertical position, so as to form a plurality of vertical channels (14) on the outer face (10) of the second panel (7).
**characterized in that** said first panel (4) is insulating and has a layer (6) made of insulating material formed by an agglomeration of resin and plastic and/or vitreous particulate, faced towards outside the containment structure (1).

10. The composite wall (1) according to claim 9, wherein said first and second panel (4, 7) are assembled together by means of profiles (16) of thermal cutting type made of aluminium alloy which form a first seat (17) for the first panel (4) and a second seat (18) for the second panel (7).
